# EUROPEAN PATENT SPECIFICATION

(11) **EP 0 476 617 B1**
(45) Date of publication and mention of the grant of the patent: **25.03.1998**
(21) Application number: 91115847.5
(22) Date of filing: 18.09.1991
(51) Int. Cl.: H01L 39/22, H01L 39/24

(54) **Superconductor junction structure and process for fabricating the same**
Supraleitende Übergangsstruktur und Verfahren zu deren Herstellung
Structure de jonction supraconducteur et procédé pour sa fabrication

(30) Priority: 18.09.1990 JP 248340/90; 20.09.1990 JP 251618/90; 09.09.1991 JP 257005/91
(43) Date of publication of application: 25.03.1992
(73) Proprietor: SUMITOMO ELECTRIC INDUSTRIES, LIMITED, Osaka 541 (JP)
(72) Inventor: Tanaka, Saburo, c/o Itami Works, Itami-shi, Hyogo (JP); Matsuura, Takashi, c/o Itami Works, Itami-shi, Hyogo (JP); Itozaki, Hideo, c/o Itami Works, Itami-shi, Hyogo (JP)
(74) Representative: Hansen, Bernd, Dr. Dipl.-Chem.

(56) References cited:
- EP-A- 0 329 507
- EP-A- 0 446 145
- EP-A- 0 467 777
- JOURNAL OF APPLIED PHYSICS vol. 67, no. 9, 1 May 1990, NEW YORK, US; pages 4217-4220; Wang X.K. et al: "Superconducting YBa2Cu307-à thin films with three different orientations"
- IEEE TRANSACTIONS ON MAGNETICS vol. 25, no. 2, March 1989, New York, US; pages 2445-2447; Wang S.Z. et al.: "Epitaxial feature of Y-Ba-Cu-O thin films prepared by multilayer deposition"
- APPLIED PHYSICS LETTERS vol. 57, no. 8, 20 August 1990, NEW YORK, US; pages 822-824; Shi W. et al.: "Influence of substrate temperature on the orientation of YBa2Cu307 films"
- APPLIED PHYSICS LETTERS vol. 57, no. 23, 3 December 1990, New York, US; pages 2484-2486; A. Inam et al.: "a-axis oriented epitaxial YBa2Cu307-x-PrBa2Cu307-y heterostructures"

## Description

### Detailed Description of the Invention

### (Field of the Invention)

The present invention relates to a superconductor junction structure. Specifically the present invention relates to a new superconductor junction structure using an oxide superconductor.

### (Related Background Art)

There are various structures for realizing superconductor junctions, which are represented by Josephson junction, and the most preferable structure is the tunnel junction comprising a thin non-superconductor (which does not have superconductive characteristics) sandwiched by a pair of superconductors. Josephson effect is exhibited by superconductor junctions, such as point-contact junctions, microbridge junction , etc., in which pairs of superconductors are weakly linked although their properties are different. Generally these superconductor junctions have very fine structures, and these superconductors and the non-superconductors are formed of the so-called films.

For example, in realizing a tunnel junction by using an oxide superconductor as the superconductors, a first oxide superconducting film, a non-superconducting film, and a second oxide superconducting film are laminated in the stated order.

As the non-superconductor, depending on applications, an insulator, e.g., MgO or others. a semiconductor, e.g., Si or others, or a metal, e.g., Au or others, is used. Tunnel superconductor junctions having such structures have different properties from one another.

The thickness of the non-superconductor of a tunnel superconductor junction is determined by a coherence length of the superconductor. The oxide superconductors have such short coherence lengths that the tunnel superconductor junctions using oxide superconductors must have the non-superconductors in a thickness of about some nano-meters.

The point contact superconductor junction and the microbridge superconductor junction require very fine processing so as to realize weak link between their pairs of superconductors.

But on the other hand, in view of the operational properties of the superconductor junctions, the respective layers must be single crystals, or polycrystals having orientations very similar to single crystals.

In the above-described tunnel superconductor junction, a first oxide superconducting film, a non-superconducting film and a second oxide superconducting film to be laminated must have good crystallinity. It is difficult to lay a oxide superconducting film of good crystallinity on an oxide superconducting film, and it is very difficult in terms of properties of the oxide superconductor to form an oxide superconducting film of good crystallinity further on the non-superconducting film.

Even when this laminar structure has been realized, the desired good properties could not be obtained due to unsatisfactory conditions of the interface between the oxide superconductor and the non-superconductor.

Furthermore, the fine processing for realizing the point contact superconductor junctions and the microbridge superconductor junctions is very difficult and as the result , it is difficult to make these superconductor junctions having stable properties with high reproducibility.

### Summary of the Invention

It is the object of the invention to provide a superconductor junction structure and a process for producing the same which use an oxide superconductor and have a new constitution, in which the above-described conventional can be successfully solved.

Accordingly, the present invention provides a superconductor junction structure comprising a two-layer structure, wherein the first layer is formed of a crystal of an oxide superconductor on a substrate and represents a c-crystallographic axis oriented crystalline film; and the second layer is formed of a crystal of an oxide superconductor, on the first layer, and represents an a-crystallographic axis oriented crystalline film, and a superconductor junction region is formed in an interface between said first layer and said second layer.

Furthermore, the present invention provides a process for fabricating a superconductor junction structure, comprising:
a first step of forming a first layer of a crystal of an oxide superconductor on a substrate at a required temperature to form a c-crystallographic orientation thereof; and
a second step of growing a crystal of the oxide superconductor on the first layer with the substrate set at a temperature lower than that of the first step to form a second layer having an a-crystallographic orientation, whereby forming a superconductor junction in an interface between the first and the second layer.

The present invention will become more fully understood from the detailed description given hereinbelow and the accompanying drawings which are given by way of illustration only, and thus are not to be considered as limiting the present invention.

Further scope of applicability of the present invention will become apparent from the detailed description given hereinafter. However, it should be understood that the detailed description and specific examples, while indicating preferred embodiments of the invention, are given by way of illustration only, since various changes and modifications within the scope of the invention as defined in the appended claims will become apparent to those skilled in the art form this detailed description.

### Brief Description of the Drawings

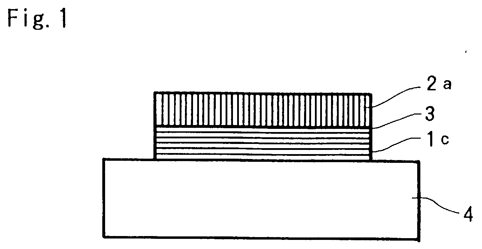

FIG. 1 is a sectional view of the superconductor junction according to the present invention.

### Description of the Preferred Embodiment

The superconductor junction structure according to the present invention comprises a first crystal layer and a second crystal layer, which are formed of the same oxide superconductor laminated on a substrate of, e.g., a metal oxide. The crystallographic axis of the first and the second crystal layers are orthogonal to each other.

FIG. 1 shows a sectional structure of a superconductor structure of the present invention. The a-crystallographic axis oriented oxide superconductor crystal layer la, and the c-crystallographic axis oriented oxide superconductor crystal lc are laminated on the substrate 4 of, e.g., a metal oxide.

The superconducting properties greatly change in an interface (a grain boundary) between the a-crystallographic oriented oxide superconductor crystal 1a and the c-crystallographic oriented oxide superconductor crystal lc, and both oxide superconductor crystals are weakly linked in the interface. In laminating the a-crystallographic axis oriented oxide superconductor film on the c-crystallographic axis oriented oxide superconductor film, unless the film forming conditions are set very strictly, the a-crystallographic axis oriented oxide superconductor film does not grow on the c-crystallographic axis oriented oxide superconductor film. Thus it necessary to consider the fine control in the making process.

The superconductor junction structure according to the present invention can be made by spattering, MBE, vacuum evaporation or laser beam abrasion. That is, the superconductor junction structure according to the present invention is fabricated by, e.g., the following process.

In the superconductor junction of the present invention a film lc of an oxide superconductor is formed on a substrate 4 heated at 560 to 580 °C. The film formed at this substrate temperature is an oxide superconducting film having an a-crystallographic axis oriented crystal. Next, the substrate 4 set at a temperature of 590 to 650 C and an oxide superconductor film 2a is formed. The film formed at this substrate temperature is an oxide superconducting film having an a-crystallographic axis oriented crystal, and the superconductor junction according to the present invention is completed.

The respective layers of the superconductor junction structure according to this invention are formed of the same raw material by basically the same process. The respective layers are formed continuously by the same apparatus, and accordingly it does not happen that the interfaces between the respective layers are exposed during respective steps of making the superconductor junction, and as the result the interface is degraded. In the superconductor junction according to the present invention, the superconducting layers are different from each other only in crystallization direction but are basically formed of the same oxide. Accordingly, even if their component atoms in one of the superconductor layers diffuse into the other layer no adverse influences is caused by the diffusion.

In the superconductor junction according to the present invention, the oxide superconductor may be optionally selected from various compounds, but Y-Ba-Cu-O oxide superconductors are preferable, because they stably form films having high-quality crystals. Bi-Sr-Ca-Cu-O oxide superconductors are preferable especially owing to their high superconductivity critical temperature Tc.

It is preferable that the superconductor junction according to the present invention is made on an oxide substrate, such as MgO, SrTiO₃, YSZ or the like.

This invention will be explained in more detail below referring examples. The following disclosure is merely examples of this invention and does not limit the technical scope of this invention.

### Example 1

The superconductor junction of FIG. 1 according to this invention was fabricated. First a c-crystallographic axis oriented Y₁Ba₂Cu₃O₇₋ₓ superconducting film as the first superconducting layer 1c was formed on the (100) plane of a MgO substrate by spattering.

The main film forming conditions are as follows.

| | | |
|---|---|---|
| Substrate temperature | | 630 °C |
| Spattering gas | Ar | 8 SCCM |
| | O₂ | 4 SCCM |
| Pressure | 6.66 Pa | (5 x 10⁻²Torr) |
| Films thickness | | 300 nm |

Next an a-crystallographic axis oriented Y₁Ba₂Cu₃O₇₋ₓ film as the second superconducting layer 2a was formed on the first superconducting film by spattering. The main film forming conditions are as follows.

| | | |
|---|---|---|
| Substrate temperature | | 570 °C |
| Spattering gas | Ar | 8 SCCM |
| | O₂ | 4 SCCM |
| Pressure | 6.66 Pa | (5 x 10⁻²Torr) |
| Films thickness | | 200 nm |

Terminals were provided on the thus-fabricated superconductor junction according to this invention, and its properties were measured. The junction was cooled down to 85 K and was supplied with a 15 G Hz frequency and a 0.2 mW microwave. Shapiro steps were observed at voltage points of multiples of 31 µV, and it was confirmed that a Josephson junction was realized.

### Example 2

The superconductor junction of FIG. 1 according to the present invention was made using Bi-Sr-Ca-CuO oxide superconductor. A c-crystallographic axis oriented Bi₂Sr₂Ca₂Cu₃Oₓ superconducting film as the first superconducting layer lc was formed on the (100) plane of a MgO substrate. The main film forming conditions are as follows.

| | | |
|---|---|---|
| Substrate temperature | | 610 °C |
| Spattering gas | Ar | 8 SCCM |
| | O₂ | 4 SCCM |
| Pressure | 6.66 Pa | (5 x 10⁻²Torr) |
| Film thickness | | 300 nm |

Next a-crystallographic axis oriented Bi₂Sr₂Ca₂Cu₃Oₓ film as the second superconducting layer 2a was formed on the superconducting film by spattering. The main film forming conditions are as follows.

| | | |
|---|---|---|
| Substrate temperature | | 580 °C |
| Spattering gas | Ar | 8 SCCM |
| | O₂ | 4 SCCM |
| Pressure | 6.66 Pa | (5 x 10⁻²Torr) |
| Films thickness | | 200 nm |

Terminals were provided on the thus-made superconductor junction according to this invention, and the properties of the junction were measured. The junction was cooled down to 90 K and was applied with a 11 GHz frequency, an 0.1 W output microwave. Shapiro steps were observed at voltage points of multiples of 22.7 µV, and it was confirmed that a Josephson junction was realized.

## Claims

1. A superconductor junction structure comprising a two-layer structure, wherein the first layer is formed of a crystal of an oxide superconductor on a substrate and represents a c-crystallographic axis oriented crystalline film; and the second layer is formed of a crystal of an oxide superconductor, on the first layer, and represents an a-crystallographic axis oriented crystalline film, and a superconductor junction region is formed in an interface between said first layer and said second layer.

2. A superconductor junction structure according to claim 1, wherein the substrate is formed of a metal oxide.

3. A superconductor junction structure according to claim 1, wherein the oxide superconductor is selected from Y-Ba-Cu-O or Bi-Sr-Ca-Cu-O group.

4. A process for fabricating a superconductor junction structure, comprising:
a first step of forming a first layer of a crystal of an oxide superconductor on a substrate at a required temperature to form a c-crystallographic orientation thereof; and
a second step of growing a crystal of the oxide superconductor on the first layer with the substrate set at a temperature lower than that of the first step to form a second layer having an a-crystallographic orientation, whereby forming a superconductor junction in an interface between the first and the second layer.

5. A process according to claim 4, wherein the temperature in the first step is of from 10 to 90K higher than that of the second step.

## Patentansprüche

1. Supraleitende Übergangsstruktur, umfassend eine zweischichtige Struktur, worin die erste Schicht aus einem Kristall eines supraleitenden Oxids auf einem Substrat gebildet ist und einen nach einer c-Kristallachse orientierten kristallinen Film darstellt; und die zweite Schicht aus einem Kristall eines supraleitenden Oxids auf der ersten Schicht gebildet ist und einen nach einer a-Kristallachse orientierten kristallinen Film darstellt, und eine supraleitende Übergangsregion an der Grenzfläche zwischen der genannten ersten Schicht und der genannten zweiten Schicht gebildet ist.

2. Supraleitende Übergangsstruktur gemäß Anspruch 1, worin das Substrat aus einem Metalloxid gebildet ist.

3. Supraleitende Übergangsstruktur gemäß Anspruch 1, worin das supraleitende Oxid aus Y-Ba-Cu-O oder aus Bi-Sr-Ca-Cu-O ausgewählt ist.

4. Verfahren zur Produktion einer supraleitenden Übergangsstruktur, umfassend
eine erste Stufe zur Bildung eines Kristalls eines supraleitenden Oxids auf einem Substrat bei einer Temperatur, die erforderlich ist, um eine c-kristallographische Orientierung hiervon herbeizuführen; und
ein zweite Stufe zur Züchtung eines Kristalls eines supraleitenden Oxids auf der ersten Schicht, wobei das Substrat auf eine Temperatur eingestellt wird, die niedriger ist als diejenige bei der ersten Stufe, um eine zweite Schicht mit einer a-kristallographischen Orientierung zu bilden, wobei ein supraleitender Zonenübergang an der Grenzfläche zwischen der ersten Schicht und der zweiten Schicht gebildet wird.

5. Verfahren gemäß Anspruch 4, worin die Temperatur in der ersten Stufe um 10 bis 90 K höher liegt als diejenige der zweiten Stufe.

## Revendications

1. Structure à jonction supraconductrice comprenant une structure à deux couches, dans laquelle la première couche est formée d'un cristal d'oxyde supraconducteur sur un substrat et représente un film cristallin orientée autour d'un axe cristallographique-c ; et la seconde couche est formée d'un cristal d'oxyde supraconducteur sur la première couche et représente un film cristallin orienté selon un axe cristallographique-a, et dans laquelle une region à jonction supraconductrice est formée dans une interface entre ladite première couche et ladite deuxième couche.

2. Structure à jonction supraconductrice selon la revendication 1, dans laquelle le substrat est formé d'un oxyde métallique.

3. Structure à jonction supraconductrice selon la revendication 1, dans laquelle le supraconducteur d'oxyde est choisi dans le groupe constitué de Y-Ba-Cu-O ou de Bi-Sr-Ca-Cu-O.

4. Procédé de fabrication d'une structure à jonction supraconductrice , comprenant :
une première étape consistant à former une première couche d'un cristal d'oxyde supraconducteur sur un substrat à une température requise pour la former selon une orientation cristallographique-c; et
une deuxième étape consistant à faire croître un cristal de l'oxyde supraconducteur sur la première couche, le substrat étant établi à une température inférieure à celle de la première étape pour former une deuxième couche ayant une orientation cristallographique-a, avec pour effet de former une jonction supraconductrice à une interface entre la première couche et la seconde couche.

5. Procédé selon la revendication 4, dans laquelle la température dans le premier étape est de 10 à 90 K plus élevée que celle de la deuxième étape.
